# EUROPEAN PATENT SPECIFICATION

(11) **EP 0 909 017 B1**
(45) Date of publication and mention of the grant of the patent: **18.06.2003**
(21) Application number: 98308209.0
(22) Date of filing: 08.10.1998
(51) Int. Cl.: H03B 5/10

(54) **Oscillator arrangements**
Oszillatoranordnungen
Agencement pour oscillateur

(30) Priority: 09.10.1997 GB 9721364
(43) Date of publication of application: 14.04.1999
(73) Proprietor: EEV LIMITED, Chelmsford, Essex, CM1 2QU (GB)
(72) Inventor: Matthews, David Richard, Chelmsford, Essex CM2 9BE (GB); Foreman, Peter Henry Dr., Chelmsford, Essex CM2 OTD (GB); Edwards, Martin Bernard, Chelmsford, Essex CM1 6FW (GB)
(74) Representative: Loveless, Ian Mark

(56) References cited:
- CH-A- 272 932
- DE-A- 3 544 412
- GB-A- 150 037
- US-A- 2 005 236
- US-A- 2 048 723
- US-A- 5 602 515

## Description

This invention relates to oscillator arrangements and more particularly to oscillator arrangements which employ a gridded electron tube having a feedback signal applied to the grid.

An electron tube such as a triode or tetrode, for example, may be operated in several different modes. A discussion of these operating classifications where a tube is used in an amplifying circuit may be found in "Radio Transmitters", First Edition 1970, by V.O. Stokes on pages 12 and 13. For Class A operation, the grid bias and alternating voltages applied to a tube are such that anode current flows continuously throughout every electrical cycle. In a Class B amplifier, the anode current flows for 180° of the cycle and provides more efficient operation than a Class A device. In Class C operation, the bias potential applied to the grid is set at a level which is above that required to cut off the tube in the static condition. Anode current flows for less than half of the alternating cycle and typically is arranged to flow for about 120°.

It has previously been proposed to modify a Class C amplifier by applying an input waveform which is rectangular instead of sinusoidal, with the biassing condition being the same as for a Class C tube. This was first suggested by Tyler and is described in British Patent Specifications GB 783,124 and GB 822,209. By applying a rectangular or square waveform to the tube, termed "Class D" operation, the amplifier operates at a higher efficiency than is obtainable from Class C operation. However, the amplifier circuit is more complex than that required for Class C operation as it includes several additional resonant circuits resonating at multiples of the fundamental output frequency. It also requires a square or rectangular waveform at the input which can be difficult to attain.

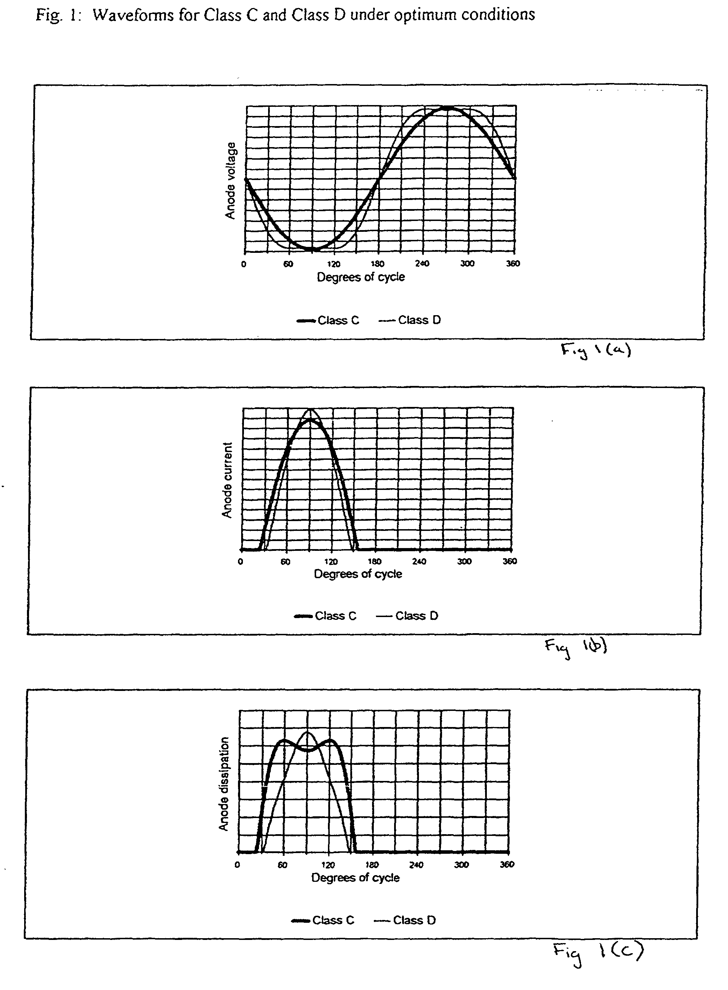

Figure 1 illustrates waveforms for Class C and Class D operation of a tube under optimum conditions. Figure 1(a) shows the anode voltage against degree of cycle, the Class C anode voltage being shown as a thicker line than the Class D anode voltage. Figure 1(b) shows the corresponding anode current and Figure 1(c) the anode dissipation. From Figure 1(a) it can be seen that the anode voltage for Class C operation is sinusoidal and the peak of the anode current coincides with the minimum anode voltage. The anode loss, and hence the efficiency of operation of the tube, is determined by integrating the product of anode current and the voltage waveform. In a Class D amplifier, the more complicated circuit includes additional resonant circuits tuned to multiples of the fundamental frequency to shape the anode and grid voltage waveforms. The anode voltage for a Class D amplifier, as shown in Figure 1(a), is squarer than the sinusoidal waveform of Class C operation. The anode voltage remains at a lower value for longer over the duration of the current pulse than for Class C operation, hence reducing anode losses and improving efficiency.

Conventionally, currently available industrial rf generators use triode based Class C oscillator circuits because of their simplicity and low cost components. The present invention seeks to provide an improved oscillator arrangement which will give good operating efficiency but be simple to implement and cost effective. The invention is particularly suited to industrial rf use such as, for example, in pipe welder equipment.

GB 150,037 discloses a valve having harmonic resonant circuitry for absorbing harmonic frequencies and a non-resonant feedback arrangement.

According to the invention, there is provided an oscillator arrangement comprising: an electron tube having a cathode, anode and control grid; a tank circuit resonant at a fundamental frequency; harmonic resonant circuit means located either between the anode and the tank circuit or between the cathode and the tank circuit; and means for applying feedback to the grid, which means does not include a harmonic resonant circuit; characterised in that the harmonic resonant circuit means comprises two resonant circuits arranged in series and stagger tuned about a harmonic resonant frequency.

The inventors have realised that it is not necessary to use a harmonic resonant circuit in both the anode circuit between the anode and the tank circuit and in the grid feedback circuit for Class D operation to be implemented in an oscillator arrangement. An arrangement in accordance with the invention gives improved efficiency resulting from Class D operation but this may also be achieved at relatively low cost without significant additional complexity compared to a Class C device. This makes Class D oscillators a practical possibility for applications where cost is a significant factor and for which such an approach would have been previously discouraged.

The provision of two stagger-tuned circuits gives an increased bandwidth, larger than was hitherto achievable with, for example, the arrangement of GB 150,037.

One advantage of the present invention is that by the addition of a simple modification circuit consisting of harmonic resonant circuit means in either the anode circuit or in the cathode circuit between the cathode and the tank circuit, an existing Class C oscillator may be converted to operate as a Class D oscillator arrangement. Converting an existing Class C oscillator to Class D operation could lead to efficiency gains of the order of 17%. Retrofitting in existing equipment may give either considerable reduction in operating costs or faster throughput.

The harmonic resonant circuit means may use low cost components and can be arranged to be easily tuned to suit a wide range of oscillator frequencies. This enables conversions from Class C oscillators to Class D oscillators to be carried out in the field with little expense and minimum downtime, an important consideration for many applications. It also permits new Class D oscillator arrangements to be readily and cheaply built.

The harmonic resonant circuit means may include an inductor, capacitor and resistor connected in parallel with one another. In an advantageous embodiment of the invention, the harmonic resonant circuit means is provided by an inductor in parallel with a series connected resistor and capacitor. In each of these embodiments, trimming of the frequency to accommodate changes in the load may be included by varying the inductance or the capacitance of variable components. The Q of the circuit may be varied by changing the ratio of the inductance to the capacitance whilst maintaining the same product of inductance and capacitance to keep the frequency constant and/or by varying the value of a resistor where this is included.

Some ways in which the invention may be performed are now described by way of example with reference to the accompanying drawings, in which:
Figure 2 schematically shows a prior art oscillator arrangement in which a harmonic resonant circuit is included in the anode circuit;
Figure 3 schematically shows part of the circuit of Figure 2 which may be added to an existing Class C oscillator arrangement to adapt it for Class D use;
Figures 4, 5 and 6 schematically illustrate various waveforms associated with the operation of the oscillator arrangement of Figure 2;
Figure 7 schematically illustrates an oscillator circuit in accordance with the invention;
Figure 8 schematically shows an oscillator arrangement in which harmonic resonant circuit means is included in the cathode circuit; and
Figure 9 illustrates a circuit providing a harmonic resonant circuit for use in converting a Class C oscillator arrangement to a Class D oscillator arrangement.

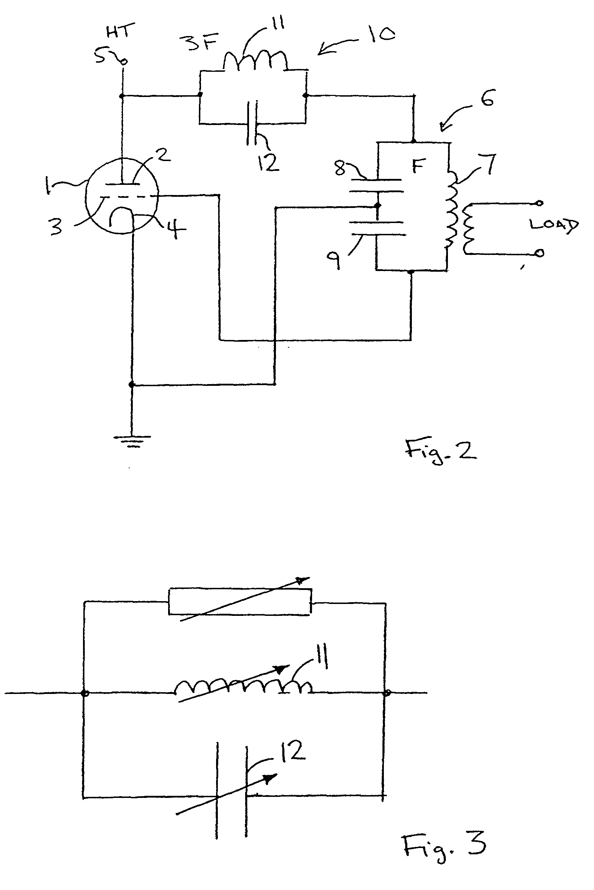

With reference to Figure 2, a prior art self starting oscillator arrangement includes a triode 1 having an anode 2, grid 3 and cathode 4 connected to an HT feed at 5. The arrangement includes a tank circuit 6 resonant at a fundamental frequency F from which the generated output signal is taken and applied to a load network (not shown). The tank circuit 6 and feedback to the grid 3 is arranged as a Colpitts circuit and includes an inductor 7 arranged in parallel with two capacitors 8 and 9. The grid 3 and anode 2 are connected to opposite ends of the tank circuit 7 and a connection is made from between the two capacitors 8 and 9 to earth and to the cathode 4.

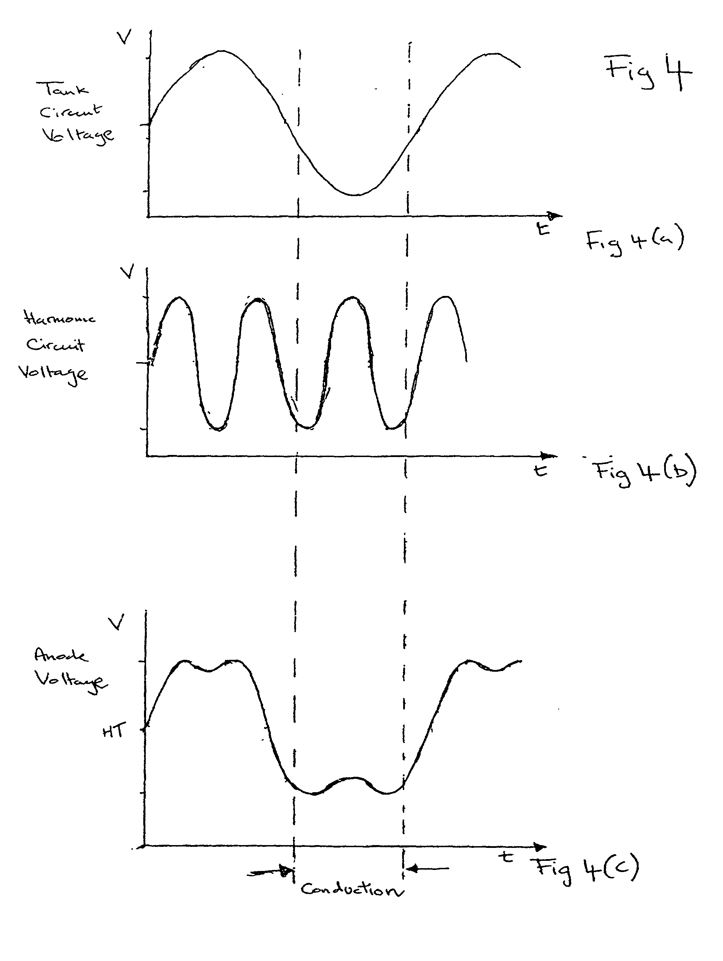

A harmonic resonant circuit 10 is included in the anode circuit between the anode 2 and the tank circuit 6. In this embodiment, the harmonic resonant circuit is resonant at 3F and comprises an inductor 11 and capacitor 12 in parallel. A damping resistor may also be included in parallel with inductor 11 and capacitor 12 as shown in Figure 3 which illustrates a harmonic resonant circuit which may be added to a Class C oscillator to convert it to Class D use. The additional damping resistor is used to set an appropriate Q value.

In use, the third harmonic of the anode current develops a voltage at the third harmonic frequency 3F in the appropriate phase across the additional harmonic resonant circuit 10. The Q of the circuit 10 determines the amplitude of the voltage. The voltage sums with the voltage across the tank circuit 6 to produce a "squared off' anode waveform, as illustrated in Figure 4. Figure 4(a) illustrates the tank circuit voltage V against time, Figure 4(b) the voltage in the harmonic resonant circuit 10 and Figure 4(c) the anode voltage. The anode waveform shown in Figure 4(c) is flatter than that which would be obtained without the harmonic resonant circuit 10 being included. From the waveforms it can be seen that the anode voltage is at a lower value during the part of the cycle when the tube 1 is conducting. Thus, anode dissipation is reduced and efficiency is greater than would be obtained with Class C operation. It should be noted that harmonic resonant circuit means is only required in one part of the oscillator circuit to give good Class D performance.

Either the inductor 11 or capacitor 12 in the harmonic resonant circuit 10 may be adjustable to allow for trimming on installation of the arrangement or during operation. Optimum tuning may be indicated by a voltmeter, oscilloscope or lamp connected across a few turns of the inductor and which detects a large signal when the harmonic resonant circuit 10 is in tune. This signal may be used to provide feedback for automatic tuning. For example, where a lamp is included, a photodetector may be used to monitor its intensity and produce a signal representative of it

Trimming of the capacitance may be achieved by means of a variable vacuum or air spaced capacitor which may be in parallel with a dielectric capacitance and may be varied by a servo mechanism to maintain tuning automatically.

Trimming of the inductance may be achieved by conventional means using tapped connections or a sliding short circuit. In another embodiment a ferrite element is used to change the inductance and may facilitate automatic tuning means either by moving the ferrite in relation to the coil or by moving a permanent magnet in relation to the ferrite or by use of a winding on the ferrite which may be used to charge its magnetic properties. The ferrite or magnet may be moved using a solenoid actuator or some other servo mechanism, or, for example, by use of a bimetallic element.

The coil on the ferrite may be used to self tune the 3F harmonic circuit by supplying current derived from the 3F inductor, for example, by rectifying the voltage across the lamp where one is included.

The anode waveform does not appear at the output of the generator. The voltage on the tank circuit 6 remains sinusoidal and the output is unaffected, as shown in Figure 4(a).

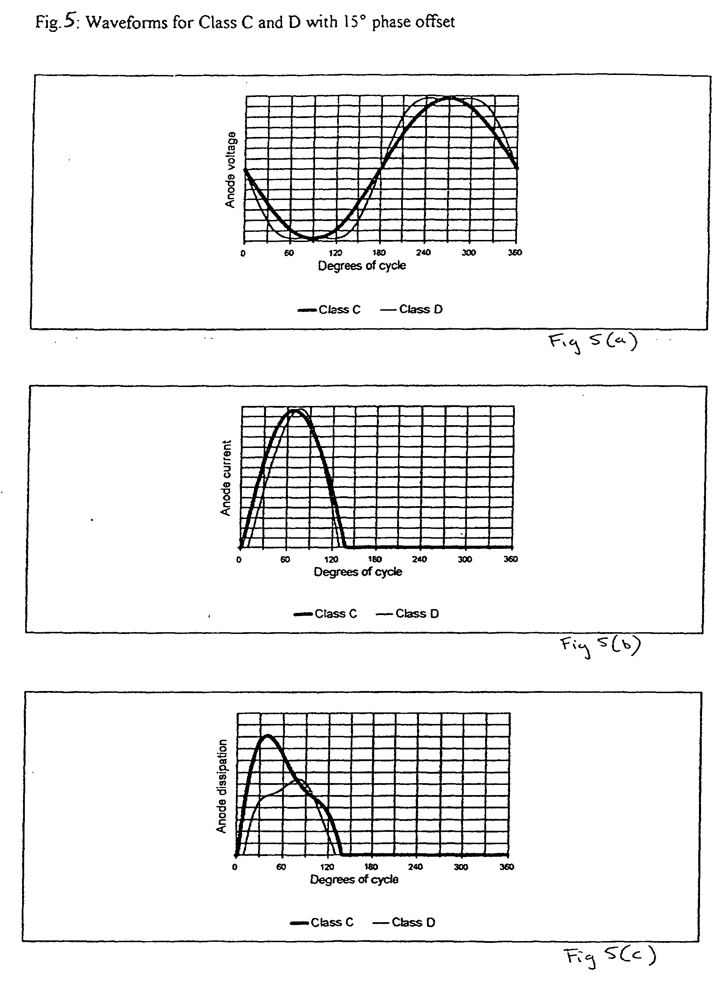

In a Class C oscillator, as used in industrial oscillators, the presence of real currents in the feedback loop means that the grid drive phasing will always be slightly incorrect. This is illustrated in Figure 5 which shows waveforms for Class C and Class D oscillators where there is a 15° phase offset, with the Class C waveforms being shown by the heavier line and those of Class D by the thinner line. Figure 5(a) shows anode voltage against degrees of cycle, Figure 5(b) the anode current and Figure 5(c) the anode dissipation against degrees of cycle. From the figures, it is clear that incorrect phasing of the feedback circuit has a significant affect on the anode losses of a Class C oscillator, reducing its efficiency. However, the Class D operation achievable with the present invention provides a more "square" anode waveform, as can be seen in Figure 5(a). Thus, anode losses will not be affected by small changes of phase, so high efficiency may be maintained even when operating conditions are not ideal, as can be seen from Figure 5(c).

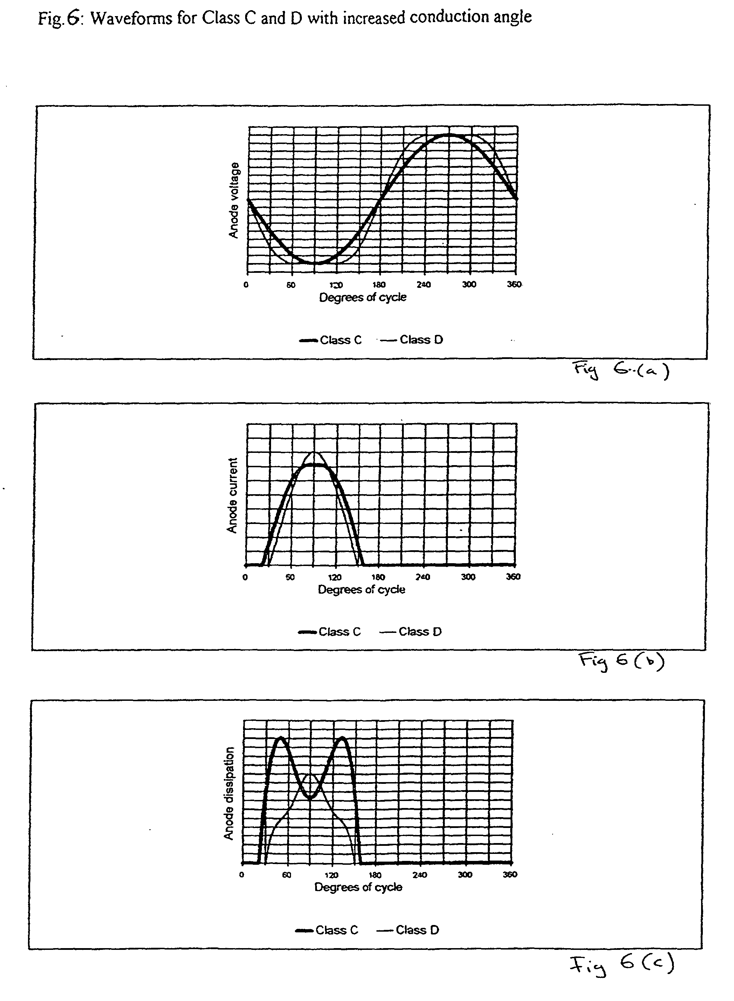

Another parameter which affects the optimum efficiency of Class C oscillators is the conduction angle. Figure 6 illustrates waveforms for Class C and D oscillators with the graphs of Figure 6(a), (b), (c) showing the same parameters as the corresponding figures for Figure 5 and again Class C waveforms being shown as a heavier line than those of Class D. It can be seen that in a Class C device, if the conduction angle is too large then the anode losses are increased, as can be seen from Figure 6(c). In contrast to this, a Class D oscillator operates in such a way that the conduction angle becomes much less critical, providing that conduction remains confined to the width of the "square" anode waveform resulting from inclusion of the harmonic resonant circuit means.

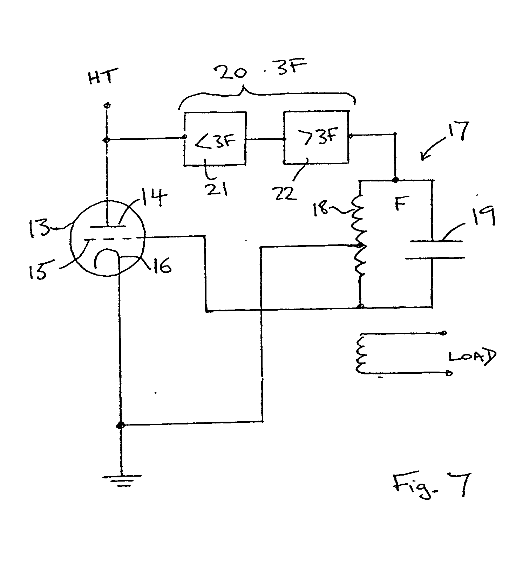

With reference to Figure 7, an oscillator arrangement in accordance with the invention includes a triode 13 having an anode 14, grid 15 and cathode 16. The tank circuit 17 which is resonant at a frequency F, the fundamental frequency, and feedback circuit are connected as a Hartley circuit, having an inductor 18 and capacitor 19 connected in parallel between the anode 14 and the grid 15. A connection to earth and to the cathode 16 is made from the inductor 18. In this embodiment of the invention, harmonic resonant circuit means is included between the anode 14 and the tank circuit 17 and again is resonant at 3F, three times the fundamental frequency at which the tank circuit 17 is resonant. In accordance with the invention, the harmonic resonant circuit means 20 comprises two resonant circuits 21 and 22 which are stagger tuned around 3F to provide an increased bandwidth. The two single tuned resonant circuits 21 and 22 are typically symmetrically de-tuned about the centre frequency 3F or may both be set just below (or above) 3F to allow for the detuning under certain operating conditions. Again, the inclusion of the harmonic resonant circuit means produces a square anode waveform to enable the oscillator to operate as a Class D device.

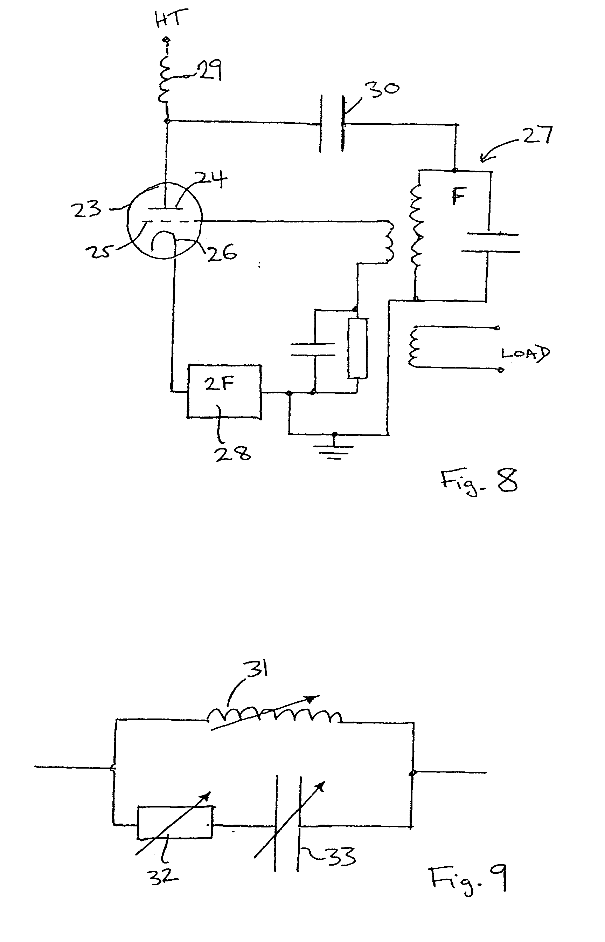

Figure 8 illustrates an oscillator arrangement in which a triode 23 having anode 24, grid 25 and cathode 26 is arranged to produced an output at a tank circuit 27 resonant at a frequency F. In this arrangement, unlike the embodiments illustrated in Figures 2 and 7, additional harmonic resonant circuit means is included in the cathode circuit at 28. There is no harmonic resonant circuit in the anode circuit which includes an r.f. choke 29 and blocking capacitor 30. In this arrangement, the additional harmonic resonant circuit 28 is tuned to two times the fundamental frequency. Although shown as a single resonant circuit, harmonic resonant circuit 28 may be provided, in accordance with the invention, by a stagger tuned pair of resonant circuits.

The harmonic resonant circuits of the oscillator arrangements of Figures 7 and 8 may include circuitry of the type illustrated in, and described above in relation to, Figure 3.

Figure 9 illustrates another additional harmonic resonant circuit which may be used to adapt a Class C oscillator arrangement to a Class D oscillator arrangement by incorporating it in either one of the anode circuit or the cathode circuit as discussed above. In this case, the modification circuit comprises an inductor 31 which is arranged in parallel with a series resistor 32 and capacitor 33. One or more of these components may be variable to give frequency trimming and for controlling the value of Q in the circuit.

Although the oscillator arrangements shown in the Figures are each triode based, the invention may also be applied to tetrodes and pentodes based oscillators.

## Claims

1. An oscillator arrangement comprising: an electron tube having a cathode (16), anode (14) and control grid (15); a tank circuit (17) resonant at a fundamental frequency; harmonic resonant circuit means (20) located either between the anode and the tank circuit or between the cathode and the tank circuit; and means for applying feedback to the grid, which means does not include a harmonic resonant circuit; **characterised in that** the harmonic resonant circuit means comprises two resonant circuits (21,22) arranged in series and stagger tuned about a harmonic resonant frequency.

2. An arrangement as claimed in claim 1 and wherein the harmonic resonant circuit means comprises circuit elements, the value of at least one of which is variable to trim the harmonic resonant frequency.

3. An arrangement as claimed in claim 2 and including means for automatically tuning the frequency of the harmonic resonant circuit means.

4. An arrangement as claimed in claim 2 or 3 and including a variable capacitor in parallel with a dielectric capacitance.

5. An arrangement as claimed in claim 2, 3 or 4 and including a ferrite element and a coil which are movable relative to one another to vary inductance.

6. An arrangement as claimed in claim 2, 3 or 4 and including a ferrite element and a permanent magnet which are movable relative to one another to vary inductance.

7. An arrangement as claimed in claim 2, 3 or 4 and including a ferrite element having a coil wound around it and means for passing current through the coil to vary inductance.

8. An arrangement as claimed in claim 7 wherein current supplied to the coil wound around the ferrite element is derived from an inductor included in the harmonic resonant circuit means.

9. An arrangement as claimed in any preceding claim wherein the harmonic resonant circuit means comprises an inductor (31) arranged in parallel with a series connected resistor (32) and capacitor (33).

10. An arrangement as claimed in any preceding claim wherein the harmonic resonant circuit means comprises an inductor (11), a capacitor (12) and a resistor connected in parallel with one another.

## Patentansprüche

1. Oszillatoranordnung, umfassend:
eine Elektronenröhre mit einer Kathode (16), einer Anode (14) und einem Steuergitter (15);
einen Tankkreis (17), der auf einer Grundfrequenz resonant ist;
eine Harmonischen-Schwingkreiseinrichtung (20), die entweder zwischen der Anode und dem Tankkreis oder zwischen der Kathode und dem Tankkreis angeordnet ist; und
Mittel zum Anlegen einer Rückkopplung an das Gitter, wobei diese Mittel keinen Harmonischen-Schwingkreis beinhalten;
**dadurch gekennzeichnet, dass**
die Harmonischen-Schwingkreiseinrichtung zwei Resonanzkreise (21, 22) umfasst, die in Reihe angeordnet sind und um eine harmonische Resonanzfrequenz herum versetzt abgestimmt sind.

2. Anordnung nach Anspruch 1, wobei die Harmonischen-Schwingkreiseinrichtung Schaltungselemente umfasst, von welchen mindestens eines in seinem Wert variable ist, um die harmonische Resonanzfrequenz nachzustimmen.

3. Anordnung nach Anspruch 2, die außerdem Mittel zum automatischen Abstimmen der Frequenz der Harmonischen-Schwingkreiseinrichtung aufweist.

4. Anordnung nach Anspruch 2 oder 3, die außerdem einen variablen Kondensator parallel zu einer dielektrischen Kapazität aufweist.

5. , Anordnung nach Anspruch 2, 3 oder 4, die außerdem ein Ferritelement und eine Spule aufweist, welche in Bezug aufeinander bewegbar sind, um die Induktivität zu variieren.

6. Anordnung nach Anspruch 2, 3 oder 4, die außerdem ein Ferritelement und einen Permanentmagneten aufweist, welche in Bezug aufeinander bewegbar sind, um die Induktivität zu variieren.

7. Anordnung nach Anspruch 2, 3 oder 4, die außerdem ein Ferritelement aufweist, um das eine Spulenwicklung gewickelt ist, sowie Mittel zum Leiten eines Stroms durch die Spulenwicklung, um die Induktivität zu variieren.

8. Anordnung nach Anspruch 7, wobei der Strom, welcher der um das Ferritelement gewickelten Spulenwicklung zugeführt wird, von einer Induktionsspule abgeleitet ist, die in der Harmonischen-Schwingkreiseinrichtung enthalten ist.

9. Anordnung nach einem der vorhergehenden Ansprüche, wobei die Harmonischen-Schwingkreiseinrichtung eine Induktionsspule (31) umfasst, die parallel zu einem in Reihe geschalteten Widerstand (32) und Kondensator (33) angeordnet ist.

10. Anordnung nach einem der vorhergehenden Ansprüche, wobei die Harmonischen-Schwingkreiseinrichtung eine Induktionsspule (11), einen Kondensator (12) und einen Widerstand umfasst, die parallel zueinander geschaltet sind.

## Revendications

1. Mécanisme oscillateur comprenant : un tube électronique ayant une cathode (16), une anode (14) et une grille de commande (15) ; un circuit bouchon (17) résonant à une fréquence fondamentale ; des moyens formant circuits résonants harmoniques (20) situés soit entre l'anode et le circuit bouchon, soit entre la cathode et le circuit bouchon ; et des moyens pour appliquer une réaction sur la grille, lesquels moyens ne comprennent pas de circuit résonant harmonique ; **caractérisé en ce que** les moyens formant circuits résonants harmoniques comprennent deux circuits résonants (21, 22) agencés en série et accordés de manière décalé à une fréquence de résonance harmonique.

2. Mécanisme selon la revendication 1, dans lequel les moyens formant circuits résonants harmoniques comprennent des éléments de circuits, l'un d'entre eux ayant au moins une valeur variable pour équilibrer la fréquence de résonance harmonique.

3. Mécanisme selon la revendication 2, comprenant des moyens pour accorder automatiquement la fréquence des moyens formant circuits résonants harmoniques.

4. Mécanisme selon la revendication 2 ou 3, comprenant un condensateur variable parallèle à une capacité diélectrique.

5. Mécanisme selon la revendication 2, 3 ou 4, comprenant un élément en ferrite et une bobine qui sont mobiles l'un par rapport à l'autre pour modifier l'inductance.

6. Mécanisme selon la revendication 2, 3 ou 4, comprenant un élément en ferrite et un aimant permanent qui sont mobiles l'un par rapport à l'autre pour modifier l'inductance.

7. Mécanisme selon la revendication 2, 3 ou 4, comprenant un élément en ferrite présentant une bobine enroulée autour de lui et des moyens pour faire passer le courant à travers la bobine pour modifier l'inductance.

8. Mécanisme selon la revendication 7, dans lequel le courant fourni à la bobine enroulée autour de l'élément en ferrite est dérivé d'un inducteur compris dans les moyens formant circuits résonants harmoniques.

9. Mécanisme selon l'une quelconque des revendications précédentes, dans lequel les moyens formant circuits résonants harmoniques comprennent un inducteur (31) agencé en parallèle avec une résistance (32) et un condensateur (33) connectés en série.

10. Mécanisme selon l'une quelconque des revendications précédentes, dans lequel les moyens formant circuits résonants harmoniques comprennent un inducteur (11), un condensateur (12) et une résistance connectés en parallèle les uns avec les autres.
